# EUROPEAN PATENT APPLICATION

(11) **EP 4 708 340 A1**
(43) Date of publication of application: **11.03.2026**
(21) Application number: 25157231.9
(22) Date of filing: 11.02.2025
(51) Int. Cl.: H01H 1/00, G01R 27/20, G01R 31/327

(54) **SYSTEM AND METHOD FOR ONLINE MONITORING OF CONTACT RESISTANCE OF BREAK OF CIRCUIT BREAKER**

(30) Priority: 04.09.2024 CN 202411234599
(71) Applicant: Tianjin Keyvia Electric Co., Ltd., Tianjin 300384 (CN)
(72) Inventor: Wang, Chuanqi, Tianjin, 300392 (CN); Geng, Likai, Tianjin, 300392 (CN); Gu, Lisuo, Tianjin, 300392 (CN); Song, Jinchuan, Tianjin, 300392 (CN); Sun, Yuechong, Tianjin, 300392 (CN); Pan, Guohua, Tianjin, 300392 (CN); Jia, Menglin, Tianjin, 300392 (CN); Liu, Wei, Tianjin, 300392 (CN)
(74) Representative: Oppermann, Frank

(57) **Abstract**

The present application provides a system and method for online monitoring of the contact resistance of a break of a circuit breaker. The system includes a main circuit formed by connecting a circuit breaker, a shunt, a load, and a power supply; a voltage transducer is connected in parallel at the break of the circuit breaker, the voltage transducer includes an auxiliary protection circuit connected in parallel at the break of the circuit breaker, the auxiliary protection circuit includes a first branch and a second branch each composed of a switch and a first resistor, the switches are connected to the break of the circuit breaker, ends of the two first resistors away from the break are each connected in parallel with a second resistor and a protection element, and end ports of the first branch and the second branch are used to collect a voltage value at the break of the circuit breaker; a current transformer is connected in parallel with two ends of the shunt, and the current transducer is used to monitor a current value at the break of the circuit breaker; and the contact resistance of the break is obtained by calculation on the basis of the voltage value and the current value being monitored. The present application can achieve online monitoring of the contact resistance of a break of a circuit breaker, and prevent the voltage transducer from burning due to over-voltage caused by breaking at the break.

## Description

### TECHNICAL FIELD

The present application relates to the field of electrical monitoring, and in particular to a system and method for online monitoring of the contact resistance of a break of a circuit breaker.

### BACKGROUND ART

In existing equipment manufacturing, when the contact resistance of a circuit breaker is measured on site, a circuit breaker trolley needs to be removed from a cabinet, and a circuit resistance tester is used for measurement. The measurement process is cumbersome. The pain point for most manufacturers is that the manufacturers cannot monitor the contact resistance of the circuit breaker online. The fundamental reason is that when the circuit breaker is opened during online monitoring of the contact resistance, a high voltage (1800V) generated will lead a monitoring device (e.g., a voltage transducer) to burning, thus resulting in a short circuit between the high-voltage side and the low-voltage side, causing a safety incident.

### SUMMARY OF THE INVENTION

In view of this, the present application is intended to propose a system and method for online monitoring of the contact resistance of a break of a circuit breaker to solve the following problem: when an existing equipment manufacturer measures the contact resistance of a circuit breaker on site, a circuit breaker trolley needs to be removed from a cabinet and a circuit resistance tester is used for measurement, and the measurement process is cumbersome, such that the contact resistance of the circuit breaker cannot be monitored online.

To achieve the above object, the technical solution of the present application is implemented as follows:
In a first aspect, the present application provides a system for online monitoring of the contact resistance of a break of a circuit breaker. The system comprises a main circuit formed by connecting a circuit breaker, a shunt, a load, and a power supply;
a voltage transducer is connected in parallel at the break of the circuit breaker, the voltage transducer comprises an auxiliary protection circuit connected in parallel at the break of the circuit breaker, the auxiliary protection circuit comprises a first branch and a second branch, the first branch and the second branch each comprise a switch and a first resistor connected to each other, the switches are connected to the break of the circuit breaker, and ends of the two first resistors away from the break are each connected in parallel with a second resistor and a protection element;
end ports of the first branch and the second branch are used to collect voltage data at the break of the circuit breaker; a current transformer is connected in parallel with two ends of the shunt, and the current transducer is used to monitor a current value at the break of the circuit breaker; and
the contact resistance of the break is obtained by calculation on the basis of the voltage value and the current value being monitored.

Further, the first resistor and the second resistor result from connecting a plurality of resistor units in series, the first resistor having a resistance value of 1MΩ, and the second resistor having a resistance value of 2MΩ.

Further, the protection element is a bidirectional TVS diode.

In a second aspect, on the basis of the same inventive concept, the present application further provides a method for online monitoring of the contact resistance of a break of a circuit breaker. The break of the circuit breaker is connected in series with a shunt, a load, and a power supply to form a main circuit for monitoring, a voltage transducer is connected in parallel at the break of the circuit breaker, and a current transducer is connected in parallel with two ends of the shunt, and the method comprises:
controlling two ends of the break of the circuit breaker to be closed, and applying a predetermined voltage;
monitoring and obtaining a circuit current by the current transducer, determining whether the circuit current meets a preset threshold range, and in response to the threshold range being met, controlling a built-in switch of the voltage transducer to be turned on and closed, so as to collect a voltage at the break of the circuit breaker; and
according to a voltage value and a current value being monitored, obtaining by calculation the contact resistance of the break on the basis of Ohm's Law.

Further, the method further comprises:
in response to the circuit current being less than a first current threshold, the voltage transducer being deactivated.

Further, the method further comprises:
in response to the circuit current being greater than the second current threshold, the break of the circuit breaker being opened and the voltage transducer being deactivated, wherein the second current threshold is greater than the first current threshold.

Further, the threshold range is set to 1kA to 4kA.

Compared with the prior art, the system and method for online monitoring of the contact resistance of a break of a circuit breaker according to the present application have the following benefits:
According to the system and method for online monitoring of the contact resistance of a break of a circuit breaker according to the present application, the system adopts a combination of a voltage transducer and a current transducer, and monitors the resistance value between contacts of the circuit breaker online by Ohm's law. Also, by means of the auxiliary protection circuit in the voltage transducer, the voltage transducer can be effectively prevented from burning due to over-voltage caused by breaking at the break.

### BRIEF DESCRIPTION OF THE DRAWINGS

The drawings, which constitute a part of the present application, are used to provide a further understanding of the present application. Illustrative embodiments of the present application and the description thereof are used to explain the present application and do not constitute improper limitation on the present application. In the drawings:
FIG. 1 is a diagram of principle of operation of a system for online monitoring of the contact resistance of a break of a circuit breaker according to an embodiment of the present application; and
FIG. 2 is a flowchart of a method for online monitoring of the contact resistance of a break of a circuit breaker according to an embodiment of the present application.

### DETAILED DESCRIPTION OF THE EMBODIMENTS

In order to make the objects, technical solutions, and advantages of the present application clearer, the present application will be further described in detail in conjunction with specific embodiments and with reference to the drawings.

It should be noted that, unless otherwise defined, the technical terms or scientific terms used in the embodiments of the present application should have the common meanings understood by those of ordinary skill in the field to which the present application pertains. "First", "second" and similar terms used in the embodiments of the present application do not indicate any order, quantity, or importance, but are only used to distinguish different components. "Comprising", "including", or a similar term means that an element or item preceding the term encompasses an element or item and its equivalents following the term, and does not exclude other elements or items. "Connected", "coupled", or a similar term is not restricted to physical or mechanical connections, but may include electrical connections, whether direct or indirect. "Up", "down", "left", "right", etc. are only used to indicate relative position relationships. When the absolute position of an object described changes, the relative position relationship may also change accordingly.

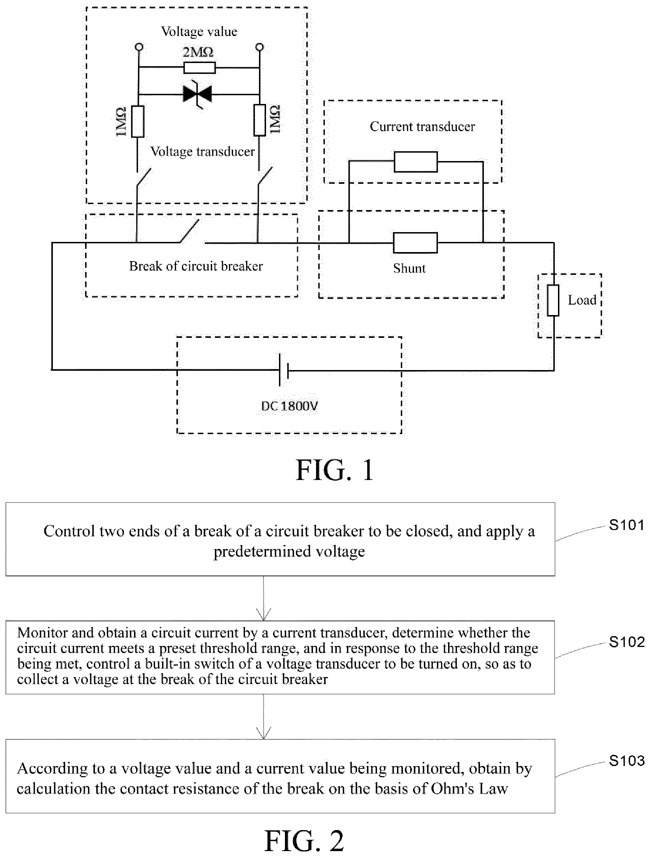

With reference to FIG. 1, the present embodiment provides a system for online monitoring of the contact resistance of a break of a circuit breaker. They system includes a main circuit formed by connecting a circuit breaker, a shunt, a load, and a power supply.

A voltage transducer is connected in parallel at the break of the circuit breaker. The voltage transducer includes an auxiliary protection circuit connected in parallel at the break of the circuit breaker. The auxiliary protection circuit includes a first branch and a second branch. The first branch and the second branch each include a switch and a first resistor connected to each other. The switches are connected to the break of the circuit breaker. Ends of the two first resistors away from the break are each connected in parallel with a second resistor and a protection element. End ports of the first branch and the second branch are used to collect a voltage value at the break of the circuit breaker. A current transformer is connected in parallel with two ends of the shunt, and the current transducer is used to monitor a current value at the break of the circuit breaker.

The contact resistance of the break is obtained by calculation on the basis of the voltage value and the current value being monitored.

Specifically, in the present embodiment, a conventional monitoring device cannot monitor the contact resistance of a circuit breaker online during monitoring of the contact resistance of a break of the circuit breaker. The fundamental reason for this is that when the circuit breaker is opened during online monitoring of the resistance of the break, a high voltage generated will lead the monitoring device to burning, thus resulting in a short circuit between the high-voltage side and the low-voltage side, causing a safety incident. This problem has not yet been effectively solved. On the basis of the existing problem, the present application proposes a system for online monitoring of the contact resistance of a break of a circuit breaker, which is based on a combination of a voltage transducer and a current transducer.

It should be noted here that in the present embodiment, the voltage transducer is used to collect the voltage at the break, while the current transducer is used to collect the voltage across two ends of the shunt to be converted into the current at the break, and the resistance between contacts of the circuit breaker is monitored online by Ohm's law.

Further, the main circuit of the present application is composed of the power supply, the load, the circuit breaker, and the shunt. The voltage transducer is connected in parallel at two ends of upper and lower copper bars of the circuit breaker to monitor the voltage at the break. The current transducer is connected in parallel at two ends of the shunt to monitor the current at the break. The voltage transducer includes an auxiliary protection circuit disposed at the break. The auxiliary protection circuit is composed of the switch, the first resistor, the second resistor and the protection element. The first resistor and the second resistor used in the present embodiment result from connecting a plurality of resistor units in series. The first resistor has a resistance value of 1MΩ and the second resistor has a resistance value of 2MΩ.The protection element used is a bidirectional transient voltage suppressor (TVS) diode.

Actions of the switch set in the present embodiment are maintained to be the same with those of the break of the circuit breaker, that is, when the break is closed, the switch of the transformer transducer is closed synchronously, and when the break is opened, the switch of the voltage transducer is opened synchronously. Accordingly, under normal circumstances, when the circuit breaker is opened, breaking occurs at the break, the switch of the voltage transducer is opened, and the current transducer and the voltage transducer do not operate. Especially, when breaking occurs at the break of the circuit breaker, a voltage spike or over-voltage may occur, which may make the switch of the voltage transducer unable to be opened in time. In this case, the bidirectional TVS diode set in the present application can still conduct the over-voltage (when the voltage exceeds the breakdown voltage of the bidirectional TVS diode, the bidirectional TVS diode will change from a high impedance state to a low impedance state, thereby conducting). The bidirectional TVS diode directs the excess voltage to a voltage divider network composed of a plurality of megohm resistors connected in series, which can effectively divide the voltage and protect the circuit from the influence of over-voltage, thereby completing the voltage division operation. By means of the voltage division operation, the over-voltage is dispersed to the plurality of resistors, the voltage on each resistor is reduced, and the heat generated is also balanced, thereby avoiding burning down of a single element due to overload. Therefore, even if the switch of the voltage transducer is unable to be opened in time, the bidirectional TVS diode can provide an additional layer of protection to prevent the voltage transducer from being damaged due to overload.

In addition, when a large current flows through the circuit or a current flows through the circuit at an excessively high rate of change, a fast release will quickly cut off the fault current to protect the system. However, this may cause a problem of opening of the break, that is, high voltage transients are generated at the break of the circuit breaker. Nonetheless, on the basis of the cooperation between the plurality of megohm resistors and the bidirectional TVS diode, the monitoring system according to the present application can effectively prevent the voltage transducer from burning due to breaking at the break caused by the fast release cutting off the fault current, and has a higher safety factor.

Since the bidirectional TVS diode can respond quickly and absorb the over-voltage, the system for online monitoring of the circuit breaker can continue to operate and will not burn due to the over-voltage caused by breaking at the break, ensuring the continuity and accuracy of monitored data.

With reference to FIG. 2, the present embodiment provides a method for online monitoring of the contact resistance of a break of a circuit breaker. The break of the circuit breaker is connected in series with a shunt, a load, and a power supply to form a main circuit for monitoring. A voltage transducer is connected in parallel at the break of the circuit breaker. A current transducer is connected in parallel with two ends of the shunt. The method specifically includes the following steps:
step S101, controlling two ends of the break of the circuit breaker to be closed, and applying a predetermined voltage;
step S 102, monitoring and obtaining a circuit current by the current transducer, determining whether the circuit current meets a preset threshold range, and in response to the threshold range being met, controlling a built-in switch of the voltage transducer to be turned on and closed, so as to collect a voltage at the break of the circuit breaker; and
step S103, according to a voltage value and a current value being monitored, obtaining by calculation the contact resistance of the break on the basis of Ohm's Law.

Specifically, in the present embodiment, it is taken into consideration that a conventional monitoring device cannot monitor the contact resistance of a circuit breaker online during monitoring of the contact resistance of a break of the circuit breaker, the fundamental reason for this is that when the circuit breaker is opened during online monitoring of the resistance of the break, a high voltage generated will lead the monitoring device to burning, thus resulting in a short circuit between the high-voltage side and the low-voltage side, causing a safety incident. On the basis of the existing problem, the present application proposes a method for online monitoring of the contact resistance of a break of a circuit breaker, which is based on a combination of a voltage transducer and a current transducer, for online monitoring of the resistance value between contacts of the circuit breaker by Ohm's law. Also, by means of the auxiliary protection circuit in the voltage transducer, the voltage transducer can be effectively prevented from burning due to over-voltage caused by breaking at the break, and the safety factor is higher.

Further, when the circuit breaker is opened, breaking occurs at the break, the built-in switch of the voltage transducer is turned on, and the voltage transducer does not operate.

When the circuit breaker completes a closing action, two ends of the break of the circuit breaker are controlled to be closed, and a voltage of 1800V is applied. The current transducer disposed at two ends of the shunt monitors a circuit current through terminal equipment (e.g., an industrial control system such as PLC or DCS) to obtain a circuit current value (in fact, the current transducer converts the collected voltage across the two ends of the shunt into the voltage at the break, and the current at the break is the circuit current). At this time, it is determined whether the monitored circuit current meets a set threshold range, where the threshold range ∈ [first current threshold, second current threshold]. When the circuit current meets the threshold range, the built-in switch of the voltage transducer is closed and turned on, and the voltage transducer starts to collect the voltage at the break. The collected voltage at the break is transmitted to the terminal equipment through an output end to obtain a break voltage value at this time. According to the collected voltage and current values, the resistance value between contacts of the circuit breaker is obtained by calculation on the basis of Ohm's law.

It should be noted that, as set in the present embodiment, the first current threshold is 1kA, and the second current threshold is 4kA, that is, the threshold range is set to 1kA to 4kA. Upon experimental verification, the voltage data within this range is more accurate, that is, the collection range is set to 1kA to 4kA.

In some embodiments, in response to the circuit current being less than the first current threshold, the voltage transducer is deactivated.

In response to the circuit current being greater than the second current threshold, the break of the circuit breaker is opened, and the voltage transducer is deactivated.

Specifically, in the present embodiment, when the circuit current is less than 1kA, the requirement set above is not met, the voltage transducer is deactivated, and the voltage transducer at this time does not collect the voltage change at the break.

When the circuit current is greater than 4kA, the fast release cuts off the fault current, and the voltage transducer does not collect the voltage change at the break.

Finally, it should be noted that the above embodiments are only used to describe the technical solutions of the present invention, rather than to limit them; although the present invention has been described in detail with reference to the above embodiments, those of ordinary skill in the art should understand that they can still modify the technical solutions described in the above embodiments, or replace some or all of the technical features therein by equivalents; and such modifications or replacements do not make the nature of the corresponding technical solutions depart from the scope of the technical solutions of the embodiments of the present invention, and such modifications or replacements should all be encompassed in the scope of the claims and description of the present invention.

The embodiments of the present application are intended to encompass all such replacements, modifications and variations that fall within the broad scope of the appended claims. Therefore, any omissions, modifications, equivalent replacements, improvements, etc. made within the spirit and principles of the embodiments of the present application should be included in the scope of protection of the present application.

## Claims

1. A system for online monitoring of the contact resistance of a break of a circuit breaker, **characterised in that**:
the system comprises a main circuit formed by connecting a circuit breaker, a shunt, a load, and a power supply;
a voltage transducer is connected in parallel at the break of the circuit breaker, the voltage transducer comprises an auxiliary protection circuit connected in parallel at the break of the circuit breaker, the auxiliary protection circuit comprises a first branch and a second branch, the first branch and the second branch each comprise a switch and a first resistor connected to each other, the switches are connected to the break of the circuit breaker, ends of the two first resistors away from the break are each connected in parallel with a second resistor and a protection element, and end ports of the first branch and the second branch are used to collect a voltage value at the break of the circuit breaker;
a current transformer is connected in parallel with two ends of the shunt, and the current transducer is used to monitor a current value at the break of the circuit breaker; and
the contact resistance of the break is obtained by calculation on the basis of the voltage value and the current value being monitored.

2. The system according to claim 1, wherein:
the first resistor and the second resistor result from connecting a plurality of resistor units in series, the first resistor having a resistance value of 1MΩ, and the second resistor having a resistance value of 2MΩ.

3. The system according to claim 1, wherein:
the protection element is a bidirectional TVS diode.

4. A method for online monitoring of the contact resistance of a break of a circuit breaker, **characterised in that**: the break of the circuit breaker is connected in series with a shunt, a load, and a power supply to form a main circuit for monitoring, a voltage transducer is connected in parallel at the break of the circuit breaker, and a current transducer is connected in parallel with two ends of the shunt, and the method comprises:
controlling two ends of the break of the circuit breaker to be closed, and applying a predetermined voltage;
monitoring and obtaining a circuit current by the current transducer, determining whether the circuit current meets a preset threshold range, and in response to the threshold range being met, controlling a built-in switch of the voltage transducer to be turned on and closed, so as to collect a voltage at the break of the circuit breaker; and
according to a voltage value and a current value being monitored, obtaining by calculation the contact resistance of the break on the basis of Ohm's Law.

5. The method according to claim 4, further comprising:
in response to the circuit current being less than a first current threshold, the voltage transducer being deactivated.

6. The method according to claim 6, further comprising:
in response to the circuit current being greater than the second current threshold, the break of the circuit breaker being opened and the voltage transducer being deactivated, wherein the second current threshold is greater than the first current threshold.

7. The method according to claim 4, wherein
the threshold range is set to 1kA to 4kA.
